(19) Europäisches Patentamt
European Patent Office
Office européen des brevets

(11) **EP 2 095 507 B1**

(12) **FASCICULE DE BREVET EUROPEEN**

(45) Date de publication et mention de la délivrance du brevet:
**21.12.2011 Bulletin 2011/51**

(21) Numéro de dépôt: **08708853.0**

(22) Date de dépôt: **11.02.2008**

(51) Int Cl.:
*H03K 5/26* (2006.01)   *G01S 7/48* (2006.01)

(86) Numéro de dépôt international:
**PCT/EP2008/051593**

(87) Numéro de publication internationale:
**WO 2008/101826 (28.08.2008 Gazette 2008/35)**

(54) **PROCEDE DE DETECTION D'IMPULSIONS LASER AU MOYEN D'UNE MATRICE DE PHOTODETECTEURS**

VERFAHREN ZUR ERKENNUNG VON LASERIMPULSEN MITHILFE EINER PHOTODETEKTORMATRIX

METHOD FOR DETECTING LASER PULSES USING A PHOTODETECTOR MATRIX

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **13.02.2007 FR 0701027**

(43) Date de publication de la demande:
**02.09.2009 Bulletin 2009/36**

(73) Titulaire: **THALES**
**92200 Neuilly-sur-Seine (FR)**

(72) Inventeur: **PRENAT, Michel**
**F-92100 Boulogne (FR)**

(74) Mandataire: **Henriot, Marie-Pierre et al**
**Marks & Clerk France**
**Conseils en Propriété Industrielle**
**Immeuble " Visium "**
**22, avenue Aristide Briand**
**94117 Arcueil Cedex (FR)**

(56) Documents cités:
**EP-A- 0 871 041     WO-A-94/17624**
**GB-A- 2 122 833**

**Description**

Le domaine de l'invention est celui de la détection d'impulsions laser au moyen d'une matrice de photodétecteurs.

On rappelle qu'une matrice de photodétecteurs effectue une conversion des photons en électrons proportionnellement à l'éclairement reçu par chaque photodétecteur dans sa bande spectrale de sensibilité, puis une intégration de ces charges dans des puits de potentiel et une lecture de ces charges. Un registre de sortie génère après amplification un signal de sortie contenant les informations de luminance de la matrice pour chacun de ses pixels. Un exemple pour un système de détection d'impulsion laser est décrit dans le document EP 0 871 041 A1.

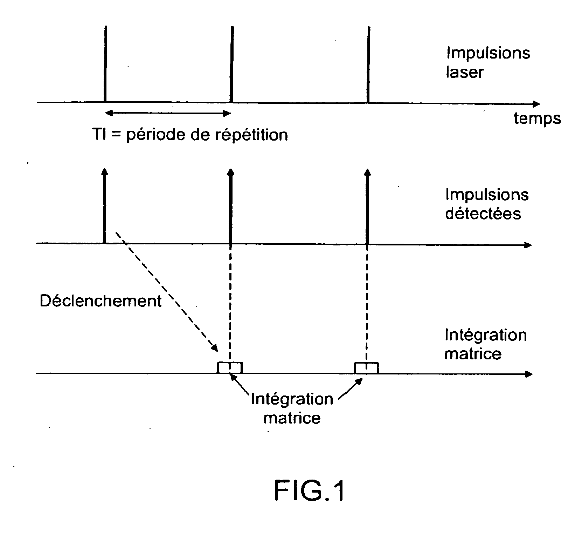

La durée d'impulsion « dl » du laser d'illumination est de l'ordre de 10 ns et la fréquence de répétition typiquement comprise entre 10 et 20 Hz soit une période comprise entre 50 et 100 ms. La matrice a une durée d'intégration voisine de une milliseconde pouvant aller par exemple d'une valeur inférieure à une milliseconde à quelques millisecondes et une période entre deux intégrations successives typiquement supérieure ou égale à 10 ms, ceci étant dû au temps nécessaire pour effectuer l'opération de lecture ; son "facteur de forme" d'intégration est alors de l'ordre de 1/10. Les phases d'intégration doivent donc être synchronisées avec les instants d'arrivée de ces impulsions. Il s'avère donc nécessaire d'adjoindre à la matrice de détection un dispositif de synchronisation apte à déclencher l'intégration lorsqu'une impulsion arrive sur la matrice. Classiquement ce dispositif de synchronisation comprend un capteur d'impulsions auxiliaire dont le récepteur est constamment ouvert et suffisamment rapide pour détecter des impulsions courtes et déterminer avec précision leur instant d'arrivée. La connaissance de la période de répétition des impulsions permet alors de déclencher l'intégration de la matrice pour les impulsions suivantes. Ainsi, dans l'art antérieur, la matrice est 'esclave' du capteur d'impulsions auxiliaire, en ce sens qu'elle dépend entièrement de lui pour le déclenchement de l'intégration. Ce processus est illustré par le schéma de la figure 1 sur lequel sont représentées en fonction du temps :

- les impulsions laser émises à une période TI,
- les impulsions détectées par le capteur auxiliaire à la même période TI et,
- les phases d'intégration de la matrice déclenchées par le capteur auxiliaire lorsqu'une impulsion est détectée pour que l'intégration soit effective à partir de l'impulsion suivante.

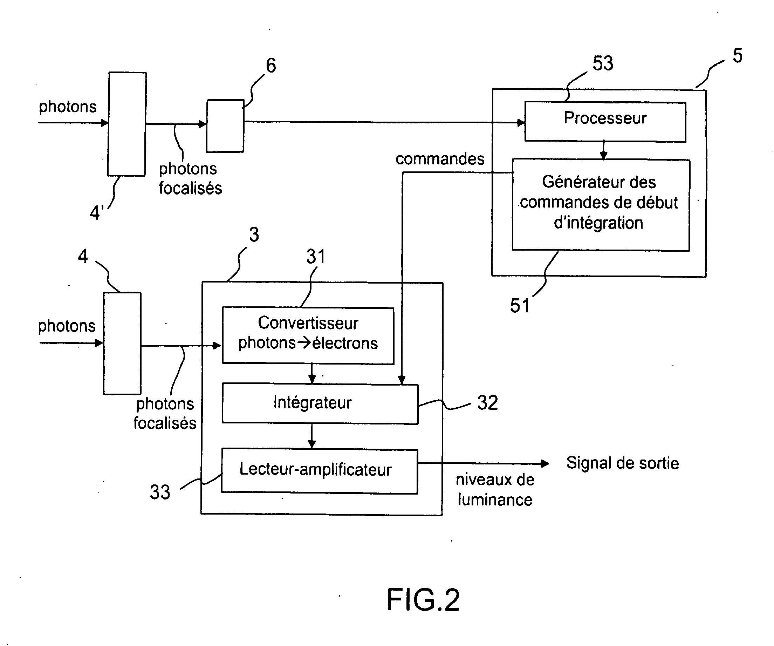

Un exemple de système de détection connu, apte à mettre en oeuvre ce processus, est décrit en relation avec la figure 2 ; il comprend une matrice 3 de photodétecteurs couplée à un capteur auxiliaire 6 via une unité de traitement 5.

Ce capteur d'impulsions rapide est par exemple un détecteur analogique monoélément. Le capteur 6 est généralement placé approximativement au foyer d'un objectif inclus dans une optique 4', dont l'axe passe par le centre du capteur, de telle sorte que l'objectif forme sur le capteur une image du point illuminé par les impulsions. Le convertisseur 31 de la matrice 3 reçoit également les photons focalisés par une autre optique 4 et convertit les photons reçus en électrons, proportionnellement à l'éclairement reçu par chaque photodétecteur. Ces charges sont ensuite intégrées par un intégrateur 32 puis lues et amplifiées par un lecteur-amplificateur 33 qui génère un signal de sortie contenant les informations de luminance de la matrice. Le capteur 6 est couplé à une unité de traitement 5 qui entre autres tâches, commande la matrice de détection 3 et notamment la phase d'intégration. Plus précisément le capteur 6 transmet les instants d'arrivée des impulsions détectées au processeur 53 de l'unité 5. Celui-ci calcule les instants de déclenchement de l'intégration et les transmet à un générateur 51 de commandes de début d'intégration. Celui envoie les commandes de déclenchement à l'intégrateur 32 de la matrice 3.

Le principe précédemment décrit présente un double inconvénient :

- la complexité et le coût car deux capteurs sont nécessaires pour assurer la fonction de détection,
- la performance : en effet, la matrice de détection est plus sensible que le détecteur mono-élément de synchronisation, puisque ce mono-élément est très grand champ, ce qui rend le système inhomogène et limité en performance par le capteur auxiliaire.

L'invention permet de supprimer ces deux inconvénients.

Plus précisément l'invention a pour objet un procédé de détection d'impulsions laser de période de répétition TI prédéterminée et de durée dl, présentant une gigue d'amplitude tj, les impulsions étant émises par un émetteur et détectées au moyen d'une matrice de photodétecteurs, le procédé comportant une étape d'intégration de charges sur une durée ti prédéterminée et selon une période Tm supérieure à une période minimale Tmin, avec ti/Tmin < 1 et dl<ti. Il est principalement caractérisé en ce que l'étape d'intégration comprend une première sous-étape pendant laquelle Tm est le plus petit sous-multiple de TI+ti-tj supérieur à Tmin jusqu'à la détection d'une première impulsion, une deuxième sous-étape avec Tm égale à TI' pendant la détection des impulsions suivantes dite phase de poursuite, avec TI' = TI x (1 - VRc/c), où VRc est la vitesse de rapprochement entre l'émetteur des impulsions et la matrice, c la vitesse de la lumière dans l'air.

La détection d'impulsions laser fonctionne de la façon séquentielle suivante

1 : détection sur le plan temporel d'un signal présentant les caractéristiques temporelles du code laser attendu, en utilisant la matrice associée à l'unité de traitement, sans recourir à un capteur auxiliaire ; on utilise pendant cette phase une période d'intégration Tm spécifique.

2 : confirmation de la détection de cette première impulsion et détection des impulsions laser suivantes. On utilise pendant cette phase une période d'intégration TI' ; celle-ci est différente de la période TI des impulsions émises par le laser en raison de la vitesse de rapprochement entre l'émetteur des impulsions et la matrice.

Ce procédé permet d'assurer la détection des impulsions laser sans recourir à un capteur auxiliaire. La matrice devient un détecteur d'impulsions autonome.

L'invention a aussi pour objet un procédé de localisation d'une cible illuminée par des impulsions laser de période de répétition TI prédéterminée et de durée dl, les impulsions rétro-réfléchies par la cible étant détectées au moyen d'une matrice de photodétecteurs, qui comprend une étape d'intégration de charges selon une période d'intégration Tm supérieure à une période minimale Tmin et sur une durée d'intégration ti prédéterminée avec $ti/Tmin < 1$ et $dl < ti$, caractérisé en ce que l'étape d'intégration comprend une première sous-étape pendant laquelle Tm est le plus petit sous-multiple de TI+ti-tj supérieur à Tmin jusqu'à la détection de la première impulsion, une deuxième sous-étape avec Tm égale à TI' pendant la détection des impulsions suivantes dite phase de poursuite, avec $TI' = TI \times (1 - VRc/c)$, où VRc est la vitesse de rapprochement entre la cible et la matrice, c la vitesse de la lumière dans l'air.

Selon une caractéristique de l'invention, ti étant la durée d'intégration pendant la première sous-étape, et la vitesse VRc étant déterminée avec une erreur, la durée d'intégration pendant la deuxième sous-étape est égale à ti+2δt, avec $\delta t = tj + (\varepsilon_{VR}/c) \times TR + dl$, où $\varepsilon_{VR}$ est un majorant de la valeur absolue de l'erreur sur la vitesse VRc, et TR est un majorant de la durée de la phase de poursuite. Dans le cas de l'alternative qui consiste à prendre TI'=TI, on prendra δt $= tj + (VRmax/c) \times TR + dl$, où VRmax est un majorant de la valeur absolue de la vitesse VRc et TR est un majorant de la durée de la phase de poursuite.

Selon une caractéristique de l'invention, tj et/ou VRc/c et/ou δt sont négligeables.

Eventuellement il comprend en outre des intégrations supplémentaires intercalées entre lesdites intégrations, l'intervalle de temps entre deux intégrations étant supérieur ou égal à Tmin. Ceci permet notamment de détecter des fausses alarmes dues par exemple à un reflet solaire.

La matrice de photodétecteurs fournissant un signal de sortie, la détection d'une impulsion comprend une étape de comparaison dudit signal de sortie avec un seuil prédéterminé.

L'invention concerne également un procédé de désignation d'une cible illuminée par des impulsions laser de période TI qui comprend une étape de localisation des impulsions rétro-réfléchies par la cible au moyen d'une matrice de photodétecteurs, selon le procédé de localisation précédent et une étape de poursuite de la cible à partir d'un rayonnement non impulsionnel de ladite cible.

Enfin, l'invention a aussi pour objet un système de détection d'impulsions laser qui comprend une matrice de photodétecteurs comportant un dispositif d'intégration de charges et une unité de traitement couplée à la matrice, caractérisé en ce que l'unité de traitement comprend des moyens de mise en oeuvre du procédé de détection décrit.

L'invention a enfin pour objet un système de localisation d'une cible qui comprend une matrice de photodétecteurs comportant un dispositif d'intégration de charges et une unité de traitement couplée à la matrice, caractérisé en ce que l'unité de traitement comprend des moyens de mise en oeuvre du procédé de localisation.

D'autres caractéristiques et avantages de l'invention apparaîtront à la lecture de la description détaillée qui suit, faite à titre d'exemple non limitatif et en référence aux dessins annexés dans lesquels :

la figure 1 déjà décrite représente schématiquement les étapes de détection d'impulsions laser selon l'état de la technique,

la figure 2 déjà décrite représente schématiquement les principaux éléments d'un exemple de dispositif de détection d'impulsions laser selon l'état de la technique,

les figures 3 représentent schématiquement les étapes de détection d'impulsions laser selon un exemple de mode d'exploitation de l'invention : jusqu'à la première détection (figure 3a), puis les détections suivantes (figure 3b),

les figures 4 illustrent les temps moyens d'acquisition d'une première impulsion selon l'invention dans un cas simplifié (figure 4a) et dans un cas plus réaliste (figure 4b),

la figure 5 représente schématiquement les principaux éléments d'un exemple d'un système de détection d'impulsions laser selon l'invention,

la figure 6 représente schématiquement un exemple de dispositif de localisation d'impulsions laser rétroréfléchies par une cible.

D'une figure à l'autre, les mêmes éléments sont repérés par les mêmes références.

Dans son application principale, l'invention concerne la détection sur le plan temporel d'un signal présentant les caractéristiques temporelles du laser attendu, en utilisant une matrice de photodétecteurs couplée à une unité de traitement, mais sans recourir à un capteur auxiliaire. L'aspect spatial est géré selon l'état de l'art.

La détection d'impulsions laser fonctionne de la façon séquentielle suivante :

1 : détection sur le plan temporel d'un signal présentant les caractéristiques temporelles du laser attendu, en utilisant seulement la matrice associée à l'unité de traitement,

2 : confirmation de la détection de cette première impulsion et détection des impulsions laser suivantes aussi désignée phase de poursuite.

On décrit dans un premier temps un mode de réalisation avec les caractéristiques de détection élémentaire suivantes :

a - quand une impulsion laser est présente pendant la durée d'intégration, sa détection est sûre, ce que l'on traduit par une probabilité de détection pd =1,

b - s'il n'y a pas d'impulsion laser pendant la durée d'intégration, il n'y a pas de fausse détection ce que l'on traduit par une probabilité de fausse détection ou fausse alarme pfa = 0.

Le problème pour la détection de la première impulsion vient du fait que la matrice ne peut intégrer que pendant une fraction du temps égale à son facteur de forme et que les instants d'arrivée des impulsions laser ne sont pas connus.

On rappelle que la période des impulsions laser est connue du système de détection qui comprend la matrice et l'unité de traitement associée, et est par exemple comprise entre 50 ms (20 Hz) et 100 ms (10 Hz).

Or la période des impulsions laser reçues au niveau de la matrice, notée TIr, est en général différente de la période TI des impulsions émises par le laser ; elles sont liées par la formule TIr = TI x (1 - VR/c) où VR est la vitesse de rapprochement entre l'émetteur des impulsions et la matrice (VR étant positif en cas de rapprochement), et c est la vitesse de la lumière dans le milieu considéré. En général, VR est connue par le système, avec une certaine erreur. On écrira VR = VRc + $\varepsilon_{VR}$, où VRc est la partie connue (ou mesurée) de VR et $\varepsilon_{VR}$ est l'erreur commise sur VR. On en déduit que TIr = TI' + $\varepsilon_{TI}$, avec TI' = TI x (1 - VRc/c) et $\varepsilon_{TI}$ = -TI* $\varepsilon_{VR}$ /c.

Prenons un exemple numérique pour illustrer ces valeurs :

soit TI = 100 ms, VR = 300 m/s, mesurée avec une erreur $\varepsilon_{VR}$ de 75 m/s, soit VRc = 225 m/s. Alors on voit que dans ce cas,

TIr = 100 ms - 100 ns, TI' = 100 ms - 75 ns et $\varepsilon_{TI}$ = - 25 ns.

La matrice a typiquement un temps d'intégration ti de 1 ms et une période supérieure à 10 ms (fréquence inférieure à 100 Hz). Le "facteur de forme" est donc typiquement inférieur à 1/10. Il est possible de commander les instants de début de chaque phase d'intégration. Les impulsions présentent une gigue de $\pm$ 20 $\mu$s par exemple autour des positions nominales c'est-à-dire des positions périodiques. La gigue est indépendante d'une impulsion à la suivante et supposée uniformément répartie entre -20 et +20 $\mu$s.

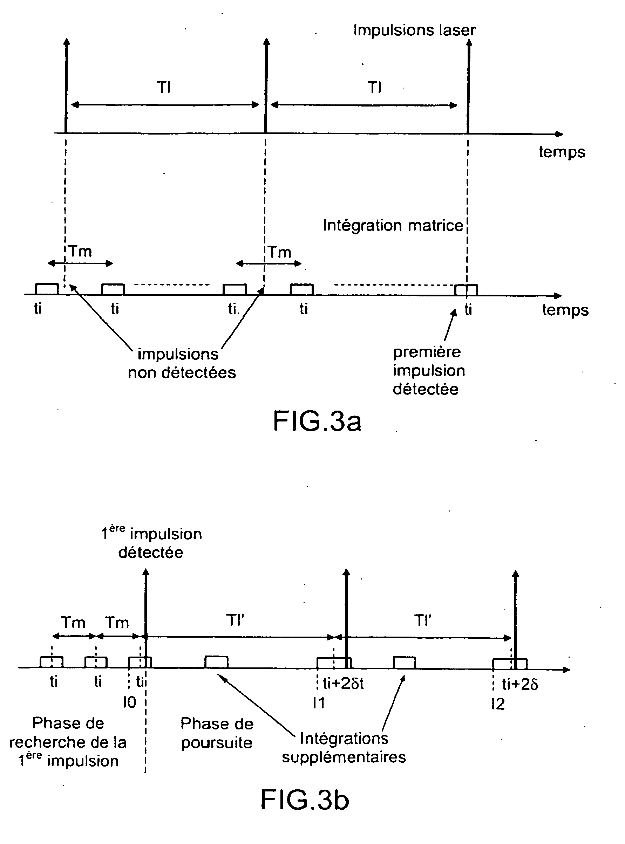

Selon ce mode de réalisation, l'étape 1 de détection de la première impulsion, illustrée figure 3a, s'effectue en deux sous-étapes :

1a) Connaissant la période du laser TI, on choisit pour la période d'intégration de la matrice Tm le plus petit sous-multiple de TI + ti - tj supérieur à Tmin, soit :

$$Tm = (TI + ti - tj) / E ((TI + ti - tj) / Tmin)$$

ti = durée d'intégration de la matrice
tj = amplitude totale de la gigue du laser
Tmin = période d'intégration minimale de la matrice
E = partie entière

Dans cette étape, l'erreur possible commise sur la connaissance de TI est négligée.

On a dans notre exemple :

TI = 75 ms, ti = 1 ms, tj = 40 µs, Tmin = 10 ms.

On obtient alors :

Tm = 75,96/ E(75,06/10) = 75,96/7 = 10,8514 ms

Avec les ordres de grandeur qui correspondent à la réalité du problème, ce choix garantit que Tm n'est pas un sous-multiple de TI. Dans le cas contraire, il y aurait un risque important pour qu'il n'y ait jamais de détection : ce risque serait de l'ordre de 90 % pour un facteur de forme d'intégration de 10%.

1b) On fait fonctionner la matrice jusqu'à la première détection.

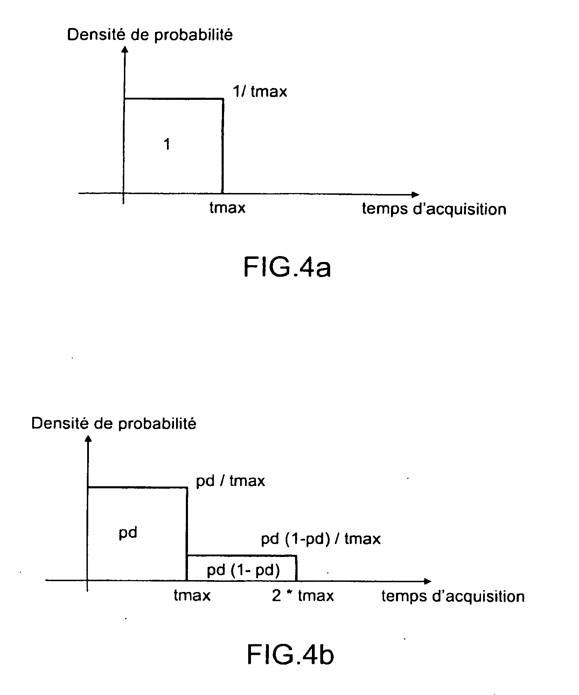

Un calcul approché indique que le temps nécessaire pour atteindre la première détection est sensiblement uniformément réparti entre 0 et tmax = TI x Tm / ti. On se reportera à la figure 4a qui représente la probabilité de détection d'une première impulsion en fonction du temps.

Dans notre exemple, ce temps est sensiblement compris entre 0 et 814 ms, avec une moyenne de 407 ms. Dans la pratique, on obtient une répartition sensiblement uniforme avec une valeur maximale de 890 ms et une valeur moyenne de 420 ms.

Cette répartition pas tout à fait uniforme et la légère différence entre le calcul approché et le résultat pratique proviennent de la conjonction de deux phénomènes aléatoires :

- La "phase" de la première impulsion laser, c'est-à-dire son instant d'arrivée par rapport à un instant quelconque pris comme origine des temps et comme début de la première intégration par la matrice.
- La gigue dont les caractéristiques ont été décrites plus haut.

Ces phénomènes aléatoires ont des conséquences sur la deuxième étape de confirmation et détection des impulsions suivantes comme le montre la figure 3b.

Le passage en détection des impulsions suivantes de l'étape 2 aussi désignée phase de poursuite, est basé sur le fait que la période des impulsions laser TI est connue. Il faut cependant prendre en compte le phénomène de gigue, la variation de TI due au rapprochement entre l'émetteur des impulsions et la matrice et l'erreur possible sur la connaissance de cette variation, ainsi que le fait que la première impulsion détectée peut se trouver à une des extrémités de la durée d'intégration.

Soit 10 l'instant de début d'intégration de la première impulsion détectée et ti0 la durée de cette intégration, désignée ti jusqu'à présent. Soient I1, 12, ...In les instants de début d'intégration suivants. I1 se déduit de I0 par un décalage égal TI' - δt, où TI' = TI (1 - VRc/c), la durée d'intégration étant alors égale à ti0 + 2δt ; ensuite les autres instants de début d'intégration (I2, ... In) se déduisent de I1 par un décalage de TI', 2TI', ... (n-1) TI', les durées d'intégration tin étant égales à ti0+2δt. On peut dire de façon équivalente que les milieux des durées d'intégration n° 1, 2, ..., n, sont décalés du milieu de la durée d'intégration n° 0 (pendant laquelle s'est produite la première détection) respectivement de TI', 2TI', ... nTI'. Ceci est illustré par la figure 3b qui fait en outre apparaître des phases d'intégration supplémentaires explicitées un peu plus loin.

Pour prendre en compte les phénomènes cités précédemment (gigue, erreur sur TIr, détection de la première impulsion en bord de durée d'intégration), on prend par exemple δt = tj + ($\varepsilon_{VR}$ /c) TR + dl, où $\varepsilon_{VR}$ est un majorant de la valeur absolue de l'erreur commise sur la vitesse de déplacement entre l'émetteur des impulsions et la matrice, c est la vitesse de la lumière dans l'air et TR est un majorant de la durée de la phase de poursuite. Dans la pratique, δt est petit devant ti.

Une alternative, utilisable dans le cas où le système ne dispose pas de mesure de VR, consiste à prendre

$$\text{TI' = TI et } \delta t = tj + (VRmax /c)TR + dl,$$

où VRmax est un majorant de la valeur absolue de la vitesse de déplacement entre l'émetteur des impulsions et la matrice.

Dans ce cas, comme pd=1, la détection des impulsions suivantes (c'est-à-dire consécutives à la première) est sûre ; il n'y a pas à proprement parler de confirmation, puisque à chaque nouvelle intégration, l'impulsion laser est détectée.

Comme indiqué précédemment, ce mode de réalisation suppose que pd = 1 et pfa = 0. Dans la réalité, la sensibilité de la matrice est suffisamment bonne pour s'approcher de ces valeurs, mais on a en fait :

pd = 1-ε $_{pd}$ où ε $_{pd}$ est petit devant 1 et
pfa non nulle, mais petite devant 1.

Pour ce qui concerne le fait que pd = 1-ε $_{pd}$, l'étape 1 de détection de la première impulsion n'a pas à être modifiée ; en effet, si la première impulsion détectable n'est pas détectée, le système ne s'en rend pas compte et continuera avec la même période de répétition Tm jusqu'à ce qu'une autre impulsion soit à nouveau en position d'être détectée, ce qui se produira après une durée égale à tmax = TI x Tm / ti (814 ms dans l'exemple).

Une probabilité de fausse alarme non nulle conduit à distinguer deux cas pour l'étape 2 de confirmation et de détection des impulsions suivantes.

- Si la première détection précédente (entre I0 et I0+ti0) est une fausse alarme, il est très vraisemblable qu'elle ne sera pas confirmée pendant l'intégration ti1 de la supposée deuxième impulsion, débutant à I1. La confirmation est par exemple basée sur la comparaison des niveaux de luminance à un seuil minimal. Il faut alors reprendre la recherche de détection là où elle était, c'est-à-dire en reprenant exactement la période Tm et le temps d'intégration ti, ce qui est justifié par le fait que I1 n'a en rien modifié le phasage du processus de recherche. L'effet sur le temps d'acquisition est très réduit : il se trouve augmenté de TI'.
- Sinon, il est très vraisemblable que la détection de la deuxième impulsion sera confirmée à I1+ti1 et le processus de détection des impulsions suivantes pourra continuer. On suppose que ce n'est pas une fausse alarme et on commande l'intégration suivante avec un écart de temps égal à TI afin de confirmer la première détection.

Ceci a un double effet : la probabilité de fausse alarme se trouve élevée au carré, donc devient dans la pratique quasiment nulle, et le temps d'acquisition se trouve augmenté de TI'. Si nécessaire, ce processus peut être répété.

La densité de probabilité des temps d'acquisition se trouve alors modifiée sensiblement comme illustré figure 4b.

Comme pd est proche de 1 (pd = 1-ε $_{pd}$), la probabilité Pd d'avoir détecté une première impulsion à 2 tmax, est égale à :

pd + pd (1-pd), soit Pd = 1 - ε $_{pd}$ $^2$ qui vaut donc quasiment 1.

Avec une telle distribution, le temps moyen d'acquisition se trouve augmenté d'une quantité égale à tmax x ε $_{pd}$, donc très faiblement (il reste très peu supérieur à tmax / 2), mais le temps maximum d'acquisition se trouve multiplié par 2. Dans la réalité, le temps d'acquisition peut encore être augmenté, si deux impulsions de suite en position d'être détectées ne sont pas détectées, ce qui se produit avec une probabilité égale à ε $_{pd}$ $^2$.

Ce raisonnement se généralise au cas où pfa n'est pas très proche de 0 et où pd n'est pas très proche de 1.

Si pfa n'est pas très proche de 0, l'absence de confirmation peut intervenir plus tard dans la phase dite 'de poursuite' ; en suivant la même logique que décrite précédemment, on voit que le temps d'acquisition sera augmenté de k x TI' au lieu de TI', k étant le nombre de fausses alarmes successives.

Si pd n'est pas très proche de 1, alors comme indiqué ci-dessus, la probabilité pour que deux impulsions consécutives en position d'être détectées ne soient pas détectées, qui est égale à ε $_{pd}$ $^2$, n'est plus négligeable et le temps maximum d'acquisition est égal à p x tmax, où p est le nombre de tentatives successives de détection nécessaires pour obtenir un résultat positif, pour des impulsions qui sont en position d'être détectées.

Dans cette phase de confirmation / poursuite, un cas particulier de fausse alarme peut être dû à la présence d'un phénomène persistant et très lumineux, comme par exemple un reflet solaire, que la matrice ne sait pas distinguer d'une impulsion de courte durée. Il est alors possible d'intercaler entre les intégrations précédentes d'autres phases d'intégration qui, si elles conduisent à détecter un signal fort, indiqueront la présence d'un signal persistant, donc d'une fausse alarme.

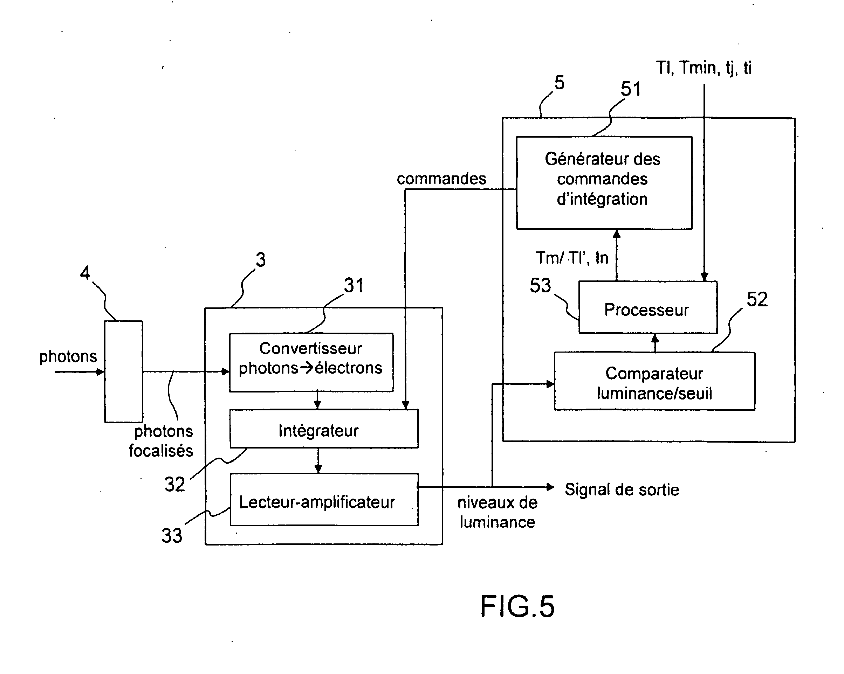

On va à présent décrire les principaux éléments d'un système de détection d'impulsions laser selon l'invention en se reportant à la figure 5.

Le convertisseur 31 de la matrice 3 reçoit les photons focalisés par l'optique 4 et convertit les photons reçus en électrons, proportionnellement à l'éclairement reçu par chaque photodétecteur. Ces charges sont ensuite intégrées par un intégrateur 32 puis lues et amplifiées par un lecteur-amplificateur 33 qui génère un signal de sortie contenant les informations de luminance de la matrice.

Ce signal est également transmis à l'unité de traitement 5 à laquelle la matrice 3 est couplée : il est transmis à un comparateur 52 qui transmet un signal au processeur 53 si ce signal est supérieur à un seuil de luminance ce qui permet notamment de confirmer une détection. Le processeur calcule la période d'intégration de l'intégrateur 32 (Tm pour l'étape 1 puis TI' pour l'étape 2) et les instants I0, I1, In de début d'intégration ainsi que les durées d'intégration (ti puis ti + 2 δt) et communique ces informations au générateur 51 des commandes d'intégration. Celui-ci génère les commandes de déclenchement et de fin de l'intégration et les envoie à l'intégrateur 32 de la matrice.

Cette matrice est par exemple une matrice en silicium ou en InGaAs, sensible à un rayonnement aux longueurs d'onde possibles des impulsions laser.

Ce procédé de détection est appliqué à la localisation d'une cible illuminée par des impulsions laser de période connue et de durée courte.

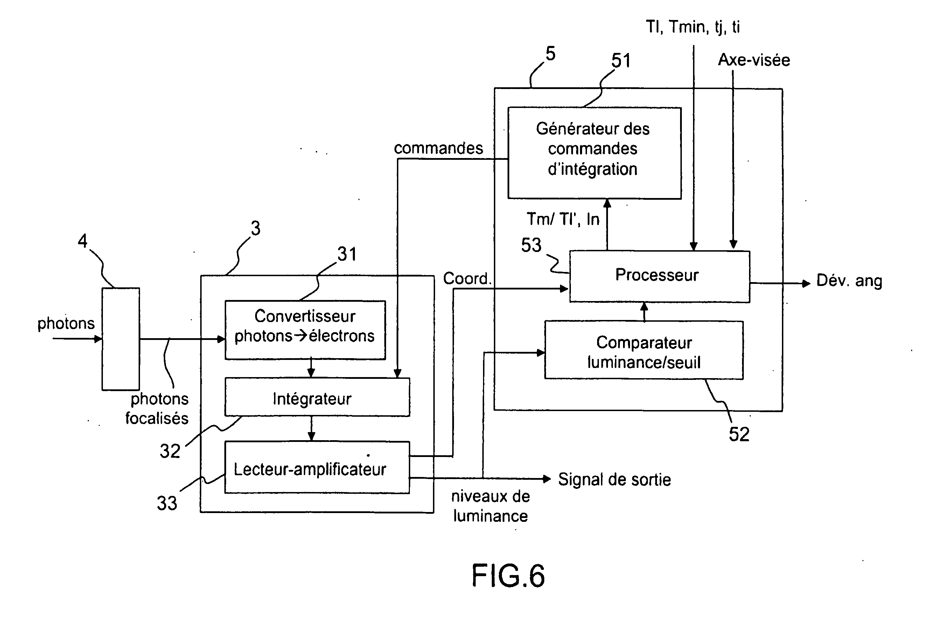

Un système de localisation d'une cible décrit en relation avec la figure 6, est typiquement équipé d'un dispositif de localisation sensible aux impulsions laser rétroréfléchies par la cible.

La localisation utilise classiquement un calcul d'écartométrie qui détermine l'écart angulaire entre l'axe de sa ligne de visée et la direction de la cible illuminée par le laser d'un émetteur associé. La direction de cette cible est repérée à partir de sa position dans le plan image d'un détecteur 3.

L'écartométrie est obtenue par une unité de traitement 5, dont le processeur 53 calcule la déviation angulaire à partir de l'axe de visée et des coordonnées fournies par le détecteur 3. On parle alors de localisation spatiale.

Le détecteur 3 comprend typiquement une matrice de photodétecteurs (ou pixels) placée dans le plan focal d'un objectif de focalisation inclus dans l'optique 4, de telle sorte que l'objectif forme sur le détecteur une image T de la tache illuminée sur la cible. Les photodétecteurs de la matrice de détection sont sensibles dans la bande de longueur d'onde des impulsions laser émises, par exemple 1,06 $\mu$m ; le matériau couramment utilisé pour cette longueur d'onde est le silicium.

La déviation angulaire est calculée à partir des coordonnées du centre de l'image T de la tache dont les pixels sont repérés en position verticale et en position horizontale respectivement sur des axes de symétrie de la matrice.

Le dispositif de localisation comprend habituellement un dispositif de synchronisation muni d'un capteur tel qu'un détecteur monoélément décrit en relation avec la figure 2, apte à synchroniser le déclenchement des phases d'intégration de la matrice de localisation avec les instants d'arrivée des impulsions sur la matrice.

Selon l'invention cette synchronisation est assurée par la matrice elle-même associée à l'unité de traitement, selon un procédé de localisation conforme au procédé précédemment décrit, ce qui rend le capteur superflu. Ce capteur est remplacé par ce procédé mis en oeuvre par l'unité de traitement.

Ce procédé de localisation s'applique à une cible illuminée par des impulsions laser de période de répétition TI prédéterminée et de durée dl, les impulsions rétro-réfléchies par la cible étant détectées au moyen d'une matrice de photodétecteurs ; il comprend une étape d'intégration de charges selon une période d'intégration Tm supérieure à une période minimale Tmin et sur une durée d'intégration ti prédéterminée avec ti/Tmin < 1 et dl<ti. L'étape d'intégration comprend une première sous-étape pendant laquelle Tm est le plus petit sous-multiple de TI+ti-tj supérieur à Tmin jusqu'à la détection de la première impulsion, une deuxième sous-étape avec Tm égale à TI' pendant la détection des impulsions suivantes dite phase de poursuite, avec TI' = TI x (1 - VRc/c), où VRc est la vitesse de rapprochement entre la cible et la matrice, c la vitesse de la lumière dans l'air.

Ce procédé de localisation peut être utilisé dans un procédé de désignation d'une cible illuminée par des impulsions laser de période de répétition TI. Ce procédé comprend outre cette étape de localisation, une étape de poursuite de la cible à partir d'un rayonnement non impulsionnel de ladite cible.

## Revendications

1. Procédé de détection d'impulsions laser de période de répétition TI prédéterminée et de durée dl, présentant une gigue d'amplitude tj, les impulsions étant émises par un émetteur et détectées au moyen d'une matrice de photodétecteurs, le procédé comportant une étape d'intégration de charges sur une durée ti prédéterminée et selon une période Tm supérieure à une période minimale Tmin, avec ti/Tmin < 1 et dl<ti, **caractérisé en ce que** l'étape d'intégration comprend une première sous-étape pendant laquelle Tm est le plus petit sous-multiple de TI+ti-tj supérieur à Tmin jusqu'à la détection d'une première impulsion, une deuxième sous-étape avec Tm égale à TI' pendant la détection des impulsions suivantes dite phase de poursuite, avec TI' = TI x (1 - VRc/c), où VRc est la vitesse de rapprochement entre l'émetteur des impulsions et la matrice, c la vitesse de la lumière dans l'air.

2. Procédé de localisation d'une cible illuminée par des impulsions laser de période de répétition TI prédéterminée et de durée dl, présentant une gigue d'amplitude tj, les impulsions rétro-réfléchies par la cible étant détectées au moyen d'une matrice de photodétecteurs, qui comprend une étape d'intégration de charges selon une période d'intégration Tm supérieure à une période minimale Tmin et sur une durée d'intégration ti prédéterminée avec ti/Tmin < 1 et dl<ti, **caractérisé en ce que** l'étape d'intégration comprend une première sous-étape pendant laquelle Tm est le plus petit sous-multiple de TI+ti-tj supérieur à Tmin jusqu'à la détection de la première impulsion, une deuxième sous-étape avec Tm égale à TI' pendant la détection des impulsions suivantes dite phase de poursuite, avec TI' = TI x (1 - VRc/c), où VRc est la vitesse de rapprochement entre la cible et la matrice, c la vitesse de la lumière dans l'air.

3. Procédé selon l'une des revendications précédentes, **caractérisé en ce que** VRc/c est négligeable.

4. Procédé selon l'une des revendications précédentes, **caractérisé en ce que** ti étant la durée d'intégration pendant la première sous-étape, et la vitesse VRc étant déterminée avec une erreur, la durée d'intégration pendant la deuxième sous-étape est égale à ti+2$\delta$t, avec $\delta$t = tj + ($\varepsilon_{VR}$ /c) x TR + dl , où $\varepsilon_{VR}$ est un majorant de la valeur absolue de l'erreur sur la vitesse VRc, et TR est,un majorant de la durée de la phase de poursuite.

5. Procédé selon la revendication précédente, **caractérisé en ce que** ti étant la durée d'intégration pendant la première sous-étape, la durée d'intégration pendant la deuxième sous-étape est égale à ti+2$\delta$t, avec $\delta$t = tj + (VRmax /c) x TR + dl , où VRmax est un majorant de la valeur absolue de la vitesse VRc et TR est un majorant de la durée de la phase de poursuite.

6. Procédé selon l'une des revendications précédentes, **caractérisé en ce que** tj est négligeable.

7. Procédé selon l'une des revendications précédentes, **caractérisé en ce que** $\delta$t est négligeable.

8. Procédé selon l'une des revendications précédentes, **caractérisé en ce qu'**il comprend en outre des intégrations supplémentaires intercalées entre lesdites intégrations, l'intervalle de temps entre deux intégrations étant supérieur ou égal à Tmin.

9. Procédé selon l'une des revendications précédentes, **caractérisé en ce que** la matrice de photodétecteurs fournissant un signal de sortie, la détection d'une impulsion comprend une étape dé comparaison dudit signal de sortie avec un seuil prédéterminé.

10. Procédé de désignation d'une cible illuminée par des impulsions laser de période TI qui comprend une étape de localisation des impulsions rétro-réfléchies par la cible au moyen d'une matrice de photodétecteurs, selon l'une des revendications 2 à 9 et une étape de poursuite de la cible à partir d'un rayonnement non impulsionnel de ladite cible.

11. Système de détection d'impulsions laser qui comprend une matrice (3) de photodétecteurs comportant un dispositif (32) d'intégration de charges et une unité de traitement (5) couplée à la matrice, **caractérisé en ce que** l'unité de traitement comprend des moyens de mise en oeuvre du procédé de détection selon la revendication 1 seule ou prise en combinaison avec l'une des revendications 3 à 9.

12. Système de localisation d'une cible qui comprend une matrice (3) de photodétecteurs comportant un dispositif (32) d'intégration de charges et une unité de traitement (5) couplée à la matrice, **caractérisé en ce que** l'unité de traitement comprend des moyens de mise en oeuvre du procédé de localisation selon l'une des revendications 2 à 9.

**Claims**

1. A method for detecting laser pulses having a pre-determined repetition period TI and duration dl, having an amplitude jitter tj, said pulses being emitted by an emitter and detected by means of a matrix of photodetectors, said method comprising a step of integrating charges over a pre-determined duration ti and according to a period Tm greater than a minimum period Tmin, with ti/Tmin < 1 and dl<ti, **characterised in that** the integrating step comprises a first sub-step during which Tm is the smallest sub-multiple of TI+ti-tj greater than Tmin until the detection of a first pulse, a second sub-step with Tm equal to TI' during the detection of the following pulses, known as the tracking phase, with TI' = TI x (1 - VRc/c), where VRc is the closing speed between the pulse emitter and the matrix, c is the speed of light in air.

2. A method for locating a target illuminated by laser pulses having a pre-determined repetition period TI and duration dl, having an amplitude jitter tj, the pulses reflected by the target being detected by means of a matrix of photodetectors, said method comprising a step of integrating charges according to an integration period Tm greater than a minimum period Tmin and over a pre-determined integration duration ti, with ti/Tmin < 1 and dl<ti, **characterised in that** the integrating step comprises a first sub-step during which Tm is the smallest sub-multiple of TI+ti-tj greater than Tmin until the detection of the first pulse, a second sub-step with Tm equal to TI' during the detection of the following pulses, known as the tracking phase, with TI' = TI x (1 - VRc/c), where VRc is the closing speed between the target and the matrix, c is the speed of light in air.

3. The method according to any one of the preceding claims, **characterised in that** VRc/c is negligible.

**4.** The method according to any one of the preceding claims, **characterised in that** as ti is the duration of integration during the first sub-step, and the speed VRc is determined with an error, the duration of integration during the second sub-step is equal to ti+2δt, with δt = tj + ($\varepsilon_{VR}$/c) x TR + dl, where $\varepsilon_{VR}$ is a majorant of the absolute value of the error on the speed VRc and TR is a majorant of the duration of the tracking phase.

**5.** The method according to the preceding claim, **characterised in that** as ti is the duration of integration during the first sub-step, the duration of integration during the second sub-step is equal to ti+2δt, with δt = tj + (VRmax/c) x TR + dl, where VRmax is a majorant of the absolute value of the speed VRc, and TR is a majorant of the duration of the tracking phase.

**6.** The method according to any one of the preceding claims, **characterised in that** tj is negligible.

**7.** The method according to any one of the preceding claims, **characterised in that** δt is negligible.

**8.** The method according to any one of the preceding claims, **characterised in that** it further comprises supplementary integrations interspersed between said integrations, the time interval between two integrations being greater than or equal to Tmin.

**9.** The method according to any one of the preceding claims, **characterised in that** the detection of a pulse comprises a step of comparing, as the matrix of photodetectors provides an output signal, said output signal with a pre-determined threshold.

**10.** A method for designating a target illuminated by laser pulses of period Tl, comprising a step of locating pulses reflected by the target by means of a matrix of photodetectors, according to any one of claims 2 to 9, and a step of tracking the target from a non-pulsed radiation of said target.

**11.** A system for detecting laser pulses, comprising a matrix (3) of photodetectors comprising a device (32) for integrating charges and a processing unit (5) connected to said matrix, **characterised in that** said processing unit comprises means for implementing the detection method according to claim 1 only or in combination with any one of claims 3 to 9.

**12.** A system for locating a target, comprising a matrix (3) of photodetectors, comprising a device (32) for integrating charges and a processing unit (5) connected to said matrix, **characterised in that** said processing unit comprises means for implementing the locating method according to any one of claims 2 to 9.

**Patentansprüche**

**1.** Verfahren zum Erkennen von Laserimpulsen mit einer vorbestimmten Wiederholperiode Tl und einer Dauer dl, mit einem Amplituden-Jitter tj, wobei die Impulse von einem Emitter ausgesendet und mittels einer Matrix von Fotodetektoren erfasst werden, wobei das Verfahren einen Schritt des Integrierens von Ladungen über eine vorbestimmte Dauer ti und gemäß einer Periode Tm größer als eine Mindestperiode Tmin beinhaltet, wobei ti/Tmin < 1 und dl<ti ist, **dadurch gekennzeichnet, dass** der Integrationsschritt einen ersten Unterschritt, während dessen Tm das kleinste Untervielfache von Tl+ti-tj größer als Tmin ist, bis ein erster Impuls erkannt wird, und einen zweiten Unterschritt beinhaltet, mit Tm gleich Tl', während der Erkennung von Folgeimpulsen, Verfolgungsphase genannt, wobei Tl' = Tl x (1 - VRc/c) ist, wobei VRc die Annäherungsgeschwindigkeit zwischen dem Inpulssender und der Matrix ist, wobei c die Lichtgeschwindigkeit in Luft ist.

**2.** Verfahren zum Orten eines Ziels, das von Laserimpulsen mit einer vorbestimmten Wiederholperiode Tl und der Dauer dl beleuchtet wird, mit einem Amplituden-Jitter tj, wobei die von dem Ziel reflektierten Impulse mittels einer Matrix von Fotodetektoren erfasst werden, wobei das Verfahren einen Schritt des Integrierens von Ladungen gemäß einer Integrationsperiode Tm größer als eine Mindestperiode Tmin und über eine vorbestimmte Integrationsdauer Ti ist, wobei ti/Tmin < 1 und dl<ti ist, **dadurch gekennzeichnet, dass** der Integrationsschritt einen ersten Unterschritt, während dessen TM das kleinste Untervielfache von Tl+ti-tj größer als Tmin bis zur Erkennung des ersten Impulses ist, und einen zweiten Unterschritt beinhaltet, bei dem Tm gleich Tl' während der Erkennung der Folgeimpulse ist, Verfolgungsphase genannt, wobei Tl' = Tl x (1 - VRc/c), wobei VRc die Annäherungsgeschwindigkeit zwischen dem Ziel und der Matrix ist, wobei c die Geschwindigkeit von Licht in Luft ist.

**3.** Verfahren nach einem der vorherigen Ansprüche, **dadurch gekennzeichnet, dass** VRc/c vernachlässigbar ist.

4.  Verfahren nach einem der vorherigen Ansprüche, **dadurch gekennzeichnet, dass**, wenn ti die Integrationsdauer während des ersten Unterschrittes ist und die Geschwindigkeit VRc mit einem Fehler erfasst wird, die Integrationsdauer während des zweiten Unterschritts gleich $ti+2\delta t$ ist, wobei $\delta t = tj + (\delta_{VR}/C) \times TR + dl$ ist, wobei $\varepsilon_{VP}$ eine Majorante des Absolutwertes des Fehlers bei der Geschwindigkeit VRc ist und TR eine Majorante der Dauer der Verfolgungsphase ist.

5.  Verfahren nach dem vorherigen Anspruch, **dadurch gekennzeichnet, dass**, wenn ti die Integrationsdauer während des ersten Unterschrittes ist, die Integrationsdauer während des zweiten Unterschritts gleich $ti+2\delta t$ ist, wobei $\delta t = tj + (VRmax/c) \times TR + dl$ ist, wobei VRmax eine Majorante des Absolutwertes der Geschwindigkeit VRc und TR eine Majorante der Dauer der Verfolgungsphase ist.

6.  Verfahren nach einem der vorherigen Ansprüche, **dadurch gekennzeichnet, dass** tj vernachlässigbar ist.

7.  Verfahren nach einem der vorherigen Ansprüche, **dadurch gekennzeichnet, dass** $\delta t$ vernachlässigbar ist.

8.  Verfahren nach einem der vorherigen Ansprüche, **dadurch gekennzeichnet, dass** es ferner zusätzliche Integrationen beinhaltet, die zwischen den Integrationen verschachtelt sind, wobei das Zeitintervall zwischen zwei Integrationen gleich oder größer als Tmin ist.

9.  Verfahren nach einem der vorherigen Ansprüche, **dadurch gekennzeichnet, dass** die Detektion eines Impulses einen Schritt des Vergleichens, wenn die Matrix von Fotodetektoren ein Ausgangssignal bereitstellt, dieses Ausgangssignals mit einem vorbestimmten Schwellenwert beinhaltet.

10. Verfahren zum Bestimmen eines von Laserimpulsen beleuchteten Ziels mit der Periode TI, das einen Schritt des Ortens von von dem Ziel reflektierten Impulsen mittels einer Matrix von Fotodetektoren beinhaltet, nach einem der Ansprüche 2 bis 9, und einen Schritt des Verfolgens des Ziels von einer nichtpulsierten Strahlung des Ziels.

11. System zum Erkennen von Laserimpulsen, das eine Matrix (3) von Fotodetektoren umfasst, umfassend eine Vorrichtung (32) zum Integrieren von Ladungen und eine mit der Matrix verbundene Verarbeitungseinheit (5), **dadurch gekennzeichnet, dass** die Verarbeitungseinheit Mittel zum Implementieren des Detektionsverfahrens nach Anspruch 1 nur oder in Kombination mit einem der Ansprüche 3 bis 9 umfasst.

12. System zum Orten eines Ziels, das eine Matrix (3) von Fotodetektoren umfasst, umfassend eine Vorrichtung (32) zum Integrieren von Ladungen und eine mit der Matrix verbundene Verarbeitungseinheit (5), **dadurch gekennzeichnet, dass** die Verarbeitungseinheit Mittel zum Implementieren des Ortungsverfahrens nach einem der Ansprüche 2 bis 9 umfasst.

Impulsions
laser

temps

TI = période de répétition

Impulsions
détectées

Déclenchement

Intégration
matrice

Intégration
matrice

# FIG.1

FIG.2

EP 2 095 507 B1

Impulsions laser

TI

TI

temps

Intégration matrice

Tm

Tm

ti      ti      ti.      ti      ti      temps

impulsions
non détectées

première
impulsion
détectée

## FIG.3a

1$^{ère}$ impulsion
détectée

Tm    Tm

TI'

TI'

ti      ti      ti
         I0

ti+2δt
I1

ti+2δ
I2

Phase de
recherche de la
1$^{ère}$ impulsion

Phase de
poursuite

Intégrations
supplémentaires

## FIG.3b

Densité de probabilité

1/ tmax

1

tmax            temps d'acquisition

# FIG.4a

Densité de probabilité

pd / tmax

pd

pd (1-pd) / tmax

pd (1- pd)

tmax        2 * tmax     temps d'acquisition

# FIG.4b

FIG.5

FIG.6

**EP 2 095 507 B1**

## RÉFÉRENCES CITÉES DANS LA DESCRIPTION

**Documents brevets cités dans la description**

- EP 0871041 A1